# EUROPEAN PATENT APPLICATION

(11) **EP 1 600 814 A2**
(43) Date of publication of application: **30.11.2005**
(21) Application number: 05253018.5
(22) Date of filing: 17.05.2005
(51) Int. Cl.: G03F 7/09

(54) **Coating compositions for use with an overcoated photoresist**

(30) Priority: 18.05.2004 US 572201
(71) Applicant: Rohm and Haas Electronic Materials, L.L.C., Marlborough, Massachusetts 01752 (US)
(72) Inventor: Coley, Suzanne, Mansfield Massachusetts 02048 (US); Trefonas III, Peter, Medway Massachusetts 02053 (US); Fallon, Patricia E., Newton Massachusetts 02460 (US); Wayton, Gerald B., Leicester Massachusetts 01524 (US)
(74) Representative: Kent, Venetia Katherine

(57) **Abstract**

Compositions and methods are provided that can reduce reflection of exposing radiation from a substrate back into an overcoated photoresist layer and/or function as a planarizing or via-fill layer. Preferred coating composition and methods of the invention can provide enhanced resolution of a patterned overcoated photoresist layer and include use of low activation temperature thermal acid generators as well as multiple thermal treatments to process a layer of the underlying coating composition.

## Description

### BACKGROUND OF THE INVENTION

### 1. Field of the Invention

The present invention relates to compositions (particularly antireflective coating compositions or "ARCs") that can reduce reflection of exposing radiation from a substrate back into an overcoated photoresist layer and/or function as a planarizing or via-fill layer. Preferred coating composition and methods of the invention can provide enhanced resolution of a patterned overcoated photoresist layer and include use of low activation temperature thermal acid generators as well as multiple thermal treatments to process a layer of the underlying coating composition.

### 2. Background

Photoresists are photosensitive films used for the transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced or chemical transformation of the photoresist coating to thereby transfer the pattern of the photomask to the photoresist-coated substrate. Following exposure, the photoresist is developed to provide a relief image that permits selective processing of a substrate. See, generally, Deforest, *Photoresist Materials and Processes,* McGraw Hill Book Company, New York, ch. 2, 1975 and Moreau, *Semiconductor Lithography, Principles, Practices and Materials,* Plenum Press, New York, ch. 2 and 4.

A major use of photoresists is in semiconductor manufacture where an object is to convert a highly polished semiconductor slice, such as silicon or gallium arsenide, into a complex matrix of electron conducting paths, preferably of micron or submicron geometry, that perform circuit functions. Proper photoresist processing is a key to attaining this object. While there is a strong interdependency among the various photoresist processing steps, exposure is believed to be one of the most important steps in attaining high resolution photoresist images.

Reflection of activating radiation used to expose a photoresist often poses limits on resolution of the image patterned in the photoresist layer. Reflection of radiation from the substrate/photoresist interface can produce spatial variations in the radiation intensity in the photoresist, resulting in non-uniform photoresist linewidth upon development. Radiation also can scatter from the substrate/photoresist interface into regions of the photoresist where exposure is non intended, again resulting in linewidth variations. The amount of scattering and reflection will typically vary from region to region, resulting in further linewidth non-uniformity. Variations in substrate topography also can give rise to resolution-limiting problems.

One approach used to reduce the problem of reflected radiation has been the use of a radiation absorbing layer interposed between the substrate surface and the photoresist coating layer. See for example, PCT Application WO 90/03598, EPO Application No. 0 639 941 A1 and U.S. Patents 4,910,122, 4370,405, 4,362,809, and 5,939,236. Such layers have also been referred to as antireflective layers or antireflective compositions. See also U.S. Patents 5,939,236; 5,886,102; 5,851,738; 5,851,730; 5,939,236; 6,165,697; 6,316,165; 6,451,503; 6,472,128; 6,502,689; 6,503,689; 6,528,235; 6,653,049; and U.S. Published Patent Applications 20030180559 and 2003008237, all assigned to the Shipley Company, which disclose highly useful antireflective compositions.

For many high performance lithographic applications, particular antireflective compositions are utilized in order to provide the desired performance properties, such as optimal absorption properties and coating characteristics. See, for instance, the above-mentioned patent documents. Nevertheless, electronic device manufacturers continually seek increased resolution of a photoresist image patterned over antireflective coating layers and in turn demand ever-increasing performance from an antireflective composition.

It thus would be desirable to have new antireflective compositions for use with an overcoated photoresist. It would be particularly desirable to have new antireflective compositions that exhibit enhanced performance and could provide increased resolution of an image patterned into an overcoated photoresist.

### SUMMARY OF THE INVENTION

We have now discovered new antireflective compositions ("ARCs") for use with an overcoated photoresist layer and new methods for use of such underlying compositions.

We unexpectedly found that applied organic antireflective composition coating layers can exhibit a withdrawal or "pull-back" from coating layer edges during thermal treatment to crosslink or otherwise harden the antireflective coating layer prior to applying an overacted photoresist layer. We further found such antireflective coating layers with withdrawn edges can adversely impact the resolution of an overcoated patterned photoresist image, particularly in such edge areas.

We then discovered that such coating layer pull-back problems could be resolved by one of several strategies, or by a combination of such strategies.

More particularly, in a first aspect, the invention provides methods for producing an electronic device which includes a two-step thermal treatment (double bake) of an applied organic coating layer. It has been found that such a double bake procedure can minimize or even essentially eliminate the noted coating layer edge pull-back phenomena. See, for instance, the comparative results set forth in the examples which follow.

Preferred methods include applying such as by spin-coating a liquid organic antireflective coating composition on a substrate such as microelectronic semiconductor wafer. The applied coating layer is then first subjected to a relatively mild (e.g., < 140°C) thermal treatment to remove the casting solvent, such as ethyl lactate, propylene glycol methyl ether acetate, anisole, amyl acetate, combinations thereof, and the like. After such solvent removal, the antireflective coating layer is subjected to a second thermal treatment that is at a temperature greater than the first, solvent-removal treatment. The higher temperature second thermal treatment preferably will effect crosslinking or other hardening of the antireflective coating layer that prevents undesired intermixing with a subsequently applied photoresist layer.

In another aspect of the invention, organic coating compositions, particularly antireflective compositions for use with an overcoated photoresist, are provided that comprise one or more thermal acid generator compounds that produce acid (e.g. an organic acid such as a sulfonate acid) upon relatively mild thermal treatment, e.g. less than about 220°C, more preferably less 200°C or less than about 180°C or 170°C. Among other things, the low temperature activation-thermal acid generator compounds can initiate early hardening of a thermally treated underlying coating composition layer.

We have found that use of such low temperature-activation thermal acid generator also can minimize the above discussed coating layer edge pull-back phenomena.

Preferred low temperature-activation thermal acid generator compounds include ionic compounds that comprise relatively low molecular weight cation components, such as sulfonate salts (generate a sulfonic acid upon thermal treatment) that have a counter ion (cation) that has a molecular weight of about 100 or less, more preferably about 80, 70, 60, 50, 40, 30 or even 20 or less such as a low molecular weight amine e.g. ammonia and the like.

In a yet further aspect of the invention, organic coating compositions, particularly antireflective compositions for use with an overcoated photoresist, are provided that comprise a resin component that comprises one or more polymers that are relatively high molecular weight, such as an Mw of at least about 10,000 daltons, more preferably an Mw of about 12,000, 15,000, 18,000, 20,000, 25,0000, 30,000, 40,000 or 50,000 daltons. Use of such high molecular weight polymers can reduce undesired edge withdrawal of an underlying composition coating layer.

In a further aspect of the invention, organic coating compositions, particularly antireflective compositions for use with an overcoated photoresist, are provided that comprise a resin component that comprises one or more polymers that have a relatively high glass transition temperature (Tg), e.g. a Tg of at least about 75°C, more preferably a Tg of at least about 80°C, 85°C, 90°C, 100°C, 110°C or 120°C. Use of such high Tg polymers can reduce undesired edge withdrawal of an underlying composition coating layer.

The invention also comprises compositions and methods that include two or more such aspects of the invention, e.g. use of an underlaying coating composition that comprises one or more low activation temperature thermal acid generator compounds and/or one or more high molecular weight polymers and/or one or more high Tg polymers in a double-bake process prior to applying an overcoated photoresist layer.

Underlying coating compositions of the invention suitably comprise a resin component in combination with one or more thermal acid generator compounds. The resin component may comprise one or more of a variety of resins including phenolic, acrylate, polyester, and other resins, and copolymers and/or blends thereof. For at least certain applications, polyester resins (including polyester copolymers) may be particularly suitable, such as provided by polymerization of a carboxy-containing compound (such as a carboxylic acid, ester, anhydride, etc.) and a hydroxy-containing compound, preferably a compound having multiple hydroxy groups such as a glycol, e.g. ethylene glycol or propylene glycol, or glycerol. Preferred polyester resins for use in underlying coating compositions of the invention are disclosed in U.S. Patent Application 20030157428.

Antireflective compositions of the invention also will contain a component that comprises chromophore groups that can absorb undesired radiation used to expose the overcoated resist layer from reflecting back into the resist layer. Generally preferred chromophores are aromatic groups, including both single ring and multiple ring aromatic groups such as optionally substituted phenyl, optionally substituted naphthyl, optionally substituted anthracenyl, optionally substituted phenanthracenyl, optionally substituted quinolinyl, and the like. Particularly preferred chromophores may vary with the radiation employed to expose an overcoated resist layer. More specifically, for exposure of an overcoated photoresist at 248 nm, optionally substituted anthracene is a particularly preferred chromophore of the antireflective composition. For exposure of an overcoated photoresist at 193 nm, optionally substituted phenyl is a particularly preferred chromophore of the antireflective composition. Preferably, such chromophore groups are linked (e.g. pendant groups) to a resin component of the antireflective composition.

Preferred underlying coating compositions of the invention can be crosslinked, particularly by thermal treatment, and may contain a separate crosslinker component that can crosslink with one ore more other components of the antireflective composition. Generally preferred crosslinking underlying coating compositions comprise a separate crosslinker component. Particularly preferred underlying coating compositions of the invention contain as separate components: a resin, a crosslinker, and a thermal acid generator additive. Thermal-induced crosslinking of the antireflective composition by activation of the thermal acid generator is preferred as discussed above.

Underlying organic coating compositions of the invention are typically formulated and applied to a substrate as an organic solvent solution. A variety of solvents, including protic solvents such as ethyl lactate an non-protic solvents such as propylene glycol methyl ether acetate can be utilized to formulate an antireflective composition of the invention.

A variety of photoresists may be used in combination (i.e. overcoated) with a coating composition of the invention. Preferred photoresists for use with the underlying coating compositions of the invention are chemically-amplified resists, especially positive-acting photoresists that contain one or more photoacid generator compounds and a resin component that contains units that undergo a deblocking or cleavage reaction in the presence of photogenerated acid, such as photoacid-labile ester, acetal, ketal or ether units. Negative-acting photoresists also can be employed with underlying coating compositions of the invention, such as resists that crosslink (i.e. cure or harden) upon exposure to activating radiation. Preferred photoresists for use with a coating composition of the invention may be imaged with relatively short-wavelength radiation, e.g. radiation having a wavelength of less than 300 nm or less than 260 nm such as about 248 nm, or radiation having a wavelength of less than about 200 nm or less than about 170 nm, such as about 193 nm or 157 nm.

The invention further provides methods for forming a photoresist relief image and electronic devices (such as a processed microelectronic wafer substrate) and novel articles of manufacture comprising substrates (such as a microelectronic wafer substrate) coated with an antireflective composition of the invention alone or in combination with a photoresist composition.

Other aspects of the invention are disclosed infra.

### DETAILED DESCRIPTION OF THE INVENTION

We now provide new organic coating compositions that are particularly useful with an overcoated photoresist layer. Preferred coating compositions of the invention may be applied by spin-coating (spin-on compositions) and formulated as a solvent (liquid) composition. The coating compositions of the invention are especially useful as antireflective compositions for an overcoated photoresist and/or as planarizing or via-fill compositions for an overcoated photoresist composition coating layer.

As discussed above, we unexpectedly found that applied organic antireflective composition coating layers can exhibit a withdrawal or "pull-back" from coating layer edges during thermal treatment to crosslink or other hardening of the antireflective coating layer prior to applying an overacted photoresist layer. We further found such antireflective coating layers with withdrawn edges can adversely impact the resolution of an overcoated patterned photoresist image, particularly in such edge areas.

Without being bound by any theory, it is currently believed that during an initial heat treatment of an underlying coating composition layer, the layer can become highly plasticized by residual casting solvent in the layer. Also, during this initial period, the coating has not begun to crosslink or otherwise harden.

During that initial heating period, it is believed that the plasticized layer may flow to minimize interfacial energies between dissimilar substrate materials; in turn, at thin point such as coating defects and edges, the coating layer may retreat (i.e. withdraw or pullback) from some surfaces. It appears possible that the rate of retreat may be proportional with several factors, including solvent content of the coating layer at the initial period of thermal treatment as well as molecular weight of polymer(s) of the coating composition resin component. Crosslinking can effectively fix the coating layer and terminate coating layer pullback that may be occurring.

We then discovered that such coating layer pull-back problems could be resolved by one of several strategies, or by a combination of such strategies.

More particularly, in a first aspect, the invention provides methods for producing an electronic device (such as an etched or plated semiconductor wafer) which includes a two-step thermal treatment (double bake) of an applied organic coating layer. It has been found that such a double bake procedure can minimize or even essentially eliminate the noted coating layer edge pull-back phenomena.

Preferred methods include applying such as by spin-coating a liquid organic antireflective coating composition on a substrate such as microelectronic semiconductor wafer. The applied coating layer is then first subjected to a relatively mild (e.g., < 140°C) thermal treatment to remove the casting solvent, such as ethyl lactate, propylene glycol methyl ether acetate, anisole, amyl acetate, combinations thereof, and the like. After such solvent removal, the antireflective coating layer is subjected to a second thermal treatment that is at a temperature greater than the first, solvent-removal treatment. The higher temperature second thermal treatment preferably will effect crosslinking or other hardening of the antireflective coating layer that prevents undesired intermixing with a subsequently applied photoresist layer.

The maximum temperature differential between the lower temperature first bake to remove solvent and the second higher temperature bake to harden the dried coating layer (i.e. the temperature difference between the maximum temperature reached during each of those two separate thermal treatments) suitably may be at least about 20°C, more typically at least about 30°C, 40°C, 50°C, 60°C, 70°C, 80°C, 90°C or even 100°C or more.

Typical maximum temperatures reached during the first solvent removal bake include at least about 100°C, 110°C, 120°C, 130°C, 140°C and 150°C, with maximum first bake (solvent removal) temperatures of from about 110°C to about 140°C being generally preferred. Maximum solvent removal temperatures (i.e. first bake temperatures) in excess of about 160°C, 170°C or 180°C are less preferred.

Typical maximum temperatures reached during the second coating layer hardening bake include at least about 180°C, 190°C, 200°C, 220°C, 240°C and 250°C, with maximum second bake hardening temperatures of from about 200°C to about 250°C being generally preferred. Maximum second bake hardening temperatures in excess of about 270°C are less preferred.

Suitable times for each of the first and second bake steps can vary, but generally the first bake will be for at least 15 seconds at the maximum bake temperature and more typically is from about 20 seconds to at least one minute at the maximum bake temperature. Bake times in excess of one minute can be utilized if desired, but are generally unnecessary to effect substantial solvent removal at temperatures of about 90°C or greater. Substantial removal of the solvent component of a coating composition of the invention will be considered to be achieved after heating a spin-coated applied coating layer of the composition on a substrate such as a microelectronic wafer for at least 15 seconds at 90°C or more.

After the first bake is completed to effect substantial removal of the casting solvent, the temperature of a coated substrate may be immediately increased to conduct the higher temperature coating layer hardening step, i.e. the dried coating layer need not be cooled prior to conducting the second higher temperature thermal treatment.

As discussed above, preferred underlying coating compositions of the invention comprise one or more thermal acid generator compounds that produce acid (e.g. an organic acid such as a sulfonate acid) upon relatively mild thermal treatment, e.g. less than about 200°C, which can initiate early hardening of a thermally underlying coating composition layer.

Even more preferably, for a composition coating layer containing the thermal acid generator (TAG) and a resin that has been spin-coated on a substrate (e.g. to a thickness of about 1300 angstroms after solvent removal), the TAG can provide free acid upon heating the coating layer at about 180°C for about 30 second or less, still more preferably for such a composition coating layer, the TAG will provide free acid upon heating the coating layer at about 170°C, 160°C, 150°C, or 140°C or less for seconds or less. References herein to conditions under which a thermal acid generator provides an acid (i.e. acid dissociated from the thermal acid generator ionic or covalent compound) means thermal treatment of such a dried 1300 angstrom thick coating layer of the thermal acid generator and a resin such as a polyester resin.

Generally preferred low activation temperature thermal acid generators are organic compounds with at least the anion component of the thermal acid generator being organic and the compound generating an organic acid upon thermal activation. For these preferred ionic thermal acid generators, the cation component need not be organic but certainly may be, with organic and inorganic amines being particularly preferred cation components.

As discussed above, the cation component preferably will have a molecular weight of less than about 100, more preferably about 80, 70 60, 50, 40, 30 or even 20 or less such as a low molecular weight amine e.g. ammonia, methyl amine, dimethyl amine, trimethylamine, and the like, with ammonia being particularly preferred. Ammonia has provided enhanced results relative to triethylamine, as shown by Examples 29-31, which follow.

Such low activation temperature thermal acid generator compounds can be readily prepared, e.g. by admixing an acid with an amine or other base in an inert solvent. See the examples which follow for exemplary procedures.

Typically one or more thermal acid generators are present in an underlying coating composition in a concentration from about 0.1 to 10 percent by weight of the total of the dry components of the composition (all components except solvent carrier), more preferably about 2 percent by weight of the total dry components.

As also discussed, preferred underlying coating composition comprise a resin component that comprises one or more polymers that are relatively high molecular weight, such as an Mw of at least about 10,000 daltons, more preferably an Mw of about 12,000, 15,000, 18,000, 20,000, 25,0000, 30,000, 40,000 or 50,000 daltons. Use of such high molecular weight polymers can reduce undesired edge withdrawal of a composition coating layer.

As also discussed above, preferred underlying coating compositions will comprise a resin component that comprises one or more polymers that have a relatively high glass transition temperature (Tg), e.g. a Tg of at least about 75°C, more preferably a Tg of at least about 80°C, 85°C, 90°C, 100°C, 110°C or 120°C. Use of such high Tg polymers can reduce undesired edge withdrawal of a composition coating layer.

A resin component of an underlying coating composition of the invention may comprise one or more of a variety of resins.

Suitable resins of an underlying coating composition include resins that contain ester repeat units. The ester groups are not photoacid-labile, i.e. the ester repeat units do not undergo deblocking or other cleavage during typical lithographic processing of preexposure bake, exposure to activating radiation, post-exposure heating, and/or development. Preferably, ester repeat units are present in the polymer backbone, i.e. the ester groups (-(C=O)O-) are present on the branched or substantially linear chain that forms the polymer length. Also preferred is that such ester groups contain aromatic substitution, e.g. a phenyl, naphthyl or anthracene group, such as may be provided by reaction of a an alkyl phthalate with a polyol.

Such a polyester resin may contain other repeat units, either as pendant or side chain units, or as other repeat units along the polymer backbone. For example, the resin may be a copolymer (e.g. two distinct repeat units along resin backbone), terpolymer (e.g. three distinct repeat units along resin backbone), tetraplymer (e.g. four distinct repeat units along polymer backbone) or pentapolymer (e.g. five distinct repeat units along polymer backbone). For instance, suitable will be polymers that contain ether and ester repeat units, or alkylene repeat units together with ester and ether units. Additional repeat units that contain one or more oxygen atoms are preferred for many applications.

Exemplary preferred resins that may be utilized in coating compositions of the invention include those that are formed by reaction of a compound that contains one or more carboxyl (e.g. ester, anhydride, carbocyclic acid) groups together with a compound that contains one or more hydroxy group preferably at least two hydroxy groups. The carboxyl-containing compound also preferably may contain two or more carboxyl (-C=OO-) groups. The carboxyl and hydroxy compound are suitably reacted in the presence of acid, optionally with other compounds if copolymer or other higher order polymer is desired, to thereby provide a polyester resin.

Such polyester resins are suitably employed by charging a reaction vessel with the a polyol, a carboxylate compound, and other compounds to be incorporated into the formed resin, an acid such as a sulfonic acid, e.g. methane sulfonic acid or para-toluene sulfonic acid, and the like. The reaction mixture is suitably stirred at an elevated temperature, e.g. at least about 80°C, more typically at least about 100°C, 110°C, 120°C, 130°C, 140°C, or 150°C for a time sufficient for polymer formation, e.g. at least about 2, 3, 4, 5, 6, 8, 12, 16, 20, 24 hours. Exemplary preferred conditions for synthesis of useful resins are detailed in the examples which follow.

Other suitable resins for use in underlying coating compositions of the invention include acrylate resins, phenolic resins and copolymers thereof. For instance, suitable resins are disclosed in U.S. Published Application 20030008237 and U.S. Patent 6,602,652. Additional preferred resins to use in an underlying coating composition include those of Formula I as disclosed on page 4 of European Published Application 813114A2 of the Shipley Company. Suitable phenolic resins, e.g. poly(vinylphenols) and novolaks, also may be employed such as those disclosed in the incorporated European Application EP 542008 of the Shipley Company. Other resins described below as photoresist resin binders also could be employed in resin binder components of underlying coating compositions of the invention.

Preferably resins of underlying coating compositions of the invention will have a weight average molecular weight (Mw) of about 1,000 to about 10,000,000 daltons, more typically about 5,000 to about 1,000,000 daltons, and a number average molecular weight (Mn) of about 500 to about 1,000,000 daltons. Molecular weights (either Mw or Mn) of the polymers of the invention are suitably determined by gel permeation chromatography.

For antireflective applications, suitably one or more of the compounds reacted to form the resin comprise a moiety that can function as a chromophore to absorb radiation employed to expose an overcoated photoresist coating layer. For example, a phthalate compound (e.g. a phthalic acid or dialkyl phthalate (i.e. di-ester such as each ester having 1-6 carbon atoms, preferably a di-methyl or ethyl phthalate) may be polymerized with an aromatic or non-aromatic polyol and optionally other reactive compounds to provide a polyester particularly useful in an antireflective composition employed with a photoresist imaged at sub-200 nm wavelengths such as 193 nm. Similarly, resins to be used in compositions with an overcoated photoresist imaged at sub-300 nm wavelengths or sub-200 nm wavelengths such as 248 nm or 193 nm, a naphthyl compound may be polymerized, such as a naphthyl compound containing one or two or more carboxyl substituents e.g. dialkyl particularly di-C₁₋₆alkyl naphthalenedicarboxylate. Reactive anthracene compounds also are preferred, e.g. an anthracene compound having one or more carboxy or ester groups, such as one or more methyl ester or ethyl ester groups.

Additionally, antireflective compositions may contain a material that contains chromophore units that is separate from the polyester resin component. For instance, the coating composition may comprise a polymeric or non-polymeric compound that contain phenyl, anthracene, naphthyl, etc. units. It is often preferred, however, that the ester-resin contain chromophore moieties.

As mentioned, preferred underlying coating compositions of the invention can be crosslinked, particularly by thermal treatment. For example, preferred underlying coating compositions of the invention may contain a separate crosslinker component that can crosslink with one ore more other components of the composition. Generally preferred crosslinking compositions comprise a separate crosslinker component. Particularly preferred underlying coating compositions of the invention contain as separate components: a resin, a crosslinker, and a thermal acid generator compound. Additionally, crosslinking coating compositions of the invention preferably can also contain an amine basic additive to promote elimination of footing or notching of the overcoated photoresist layer. Crosslinking coating compositions are preferably crosslinked prior to application of a photoresist layer over the composition coating layer to avoid undesired intermixing of the two coating layers.

The concentration of such a resin component of the coating compositions of the invention may vary within relatively broad ranges, and in general the resin binder is employed in a concentration of from about 50 to 95 weight percent of the total of the dry components of the coating composition, more typically from about 60 to 90 weight percent of the total dry components (all components except solvent carrier).

As discussed above, crosslinking-type coating compositions of the invention also contain a crosslinker component. A variety of crosslinkers may be employed, including those antireflective composition crosslinkers disclosed in Shipley European Application 542008 incorporated herein by reference. For example, suitable antireflective composition crosslinkers include amine-based crosslinkers such as melamine materials, including melamine resins such as manufactured by American Cyanamid and sold under the tradename of Cymel 300, 301, 303, 350, 370, 380, 1116 and 1130. Glycolurils are particularly preferred including glycolurils available from American Cyanamid. Benzoquanamines and urea-based materials also will be suitable including resins such as the benzoquanamine resins available from American Cyanamid under the name Cymel 1123 and 1125, and urea resins available from American Cyanamid under the names of Beetle 60, 65, and 80. In addition to being commercially available, such amine-based resins may be prepared e.g. by the reaction of acrylamide or methacrylamide copolymers with formaldehyde in an alcohol-containing solution, or alternatively by the copolymerization ofN-alkoxymethyl acrylamide or methacrylamide with other suitable monomers.

Suitable substantially neutral crosslinkers include hydroxy compounds, particularly polyfunctional compounds such as phenyl or other aromatics having one or more hydroxy or hydroxy alkyl substitutents such as a C₁₋₈hydroxyalkyl substitutents. Phenol compounds are generally preferred such as di-methanolphenol (C₆H₃(CH₂OH)₂)H) and other compounds having adjacent (within 1-2 ring atoms) hydroxy and hydroxyalkyl substitution, particularly phenyl or other aromatic compounds having one or more methanol or other hydroxylalkyl ring substituent and at least one hydroxy adjacent such hydroxyalkyl substituent.

It has been found that a substantially neutral crosslinker such as a methoxy methylated glycoluril used in antireflective compositions of the invention can provide excellent lithographic performance properties, including significant reduction (SEM examination) of undercutting or footing of an overcoated photoresist relief image.

A crosslinker component of an underlying coating composition of the invention in general is present in an amount of between about 5 and 50 weight percent of total solids (all components except solvent carrier) of the coating composition, more typically in an amount of about 7 to 25 weight percent total solids.

Coating compositions of the invention, particularly for reflection control applications, also may contain additional dye compounds that absorb radiation used to expose an overcoated photoresist layer. Other optional additives include surface leveling agents, for example, the leveling agent available under the tradename Silwet 7604 from Union Carbide, or the surfactant FC 171 or FC 431 available from the 3M Company.

Coating compositions of the invention also may contain one or more photoacid generator compound typically in addition to another acid source such as an acid or thermal acid generator compound. In such use of a photoacid generator compound (PAG), the photoacid generator is not used as an acid source for promoting a crosslinking reaction, and thus preferably the photoacid generator is not substantially activated during crosslinking of the coating composition (in the case of a crosslinking coating composition). Such use of photoacid generators is disclosed in U.S. Patent 6,261,743 assigned to the Shipley Company. In particular, with respect to coating compositions that are thermally crosslinked, the coating composition PAG should be substantially stable to the conditions of the crosslinking reaction so that the PAG can be activated and generate acid during subsequent exposure of an overcoated resist layer. Specifically, preferred PAGs do not substantially decompose or otherwise degrade upon exposure of temperatures of from about 140 or 150 to 190°C for 5 to 30 or more minutes.

Generally preferred photoacid generators for such use in underlying coating compositions of the invention include e.g. onium salts such as di(4-tert-butylphenyl)iodonium perfluoroctane sulphonate, halogenated non-ionic photoacid generators such as 1,1-bis[p-chlorophenyl]-2,2,2-trichloroethane, and other photoacid generators disclosed for use in photoresist compositions. For at least some antireflective compositions of the invention, antireflective composition photoacid generators will be preferred that can act as surfactants and congregate near the upper portion of the antireflective composition layer proximate to the antireflective composition/resist coating layers interface. Thus, for example, such preferred PAGs may include extended aliphatic groups, e.g. substituted or unsubstituted alkyl or alicyclic groups having 4 or more carbons, preferably 6 to 15 or more carbons, or fluorinated groups such as C₁₋₁₅alkyl or C₂-₁₅alkenyl having one or preferably two or more fluoro substituents.

Various substituents and materials (including resins, small molecule compounds, acid generators, etc.) as being "optionally substituted" may be suitably substituted at one or more available positions by e.g. halogen (F, Cl, Br, I); nitro; hydroxy; amino; alkyl such as C₁₋₈ alkyl; alkenyl such as C₂₋₈ alkenyl; alkylamino such as C₁₋₈ alkylamino; carbocyclic aryl such as phenyl, naphthyl, anthracenyl, etc; and the like.

To make a liquid coating composition of the invention, the components of the coating composition are dissolved in a suitable solvent such as, for example, one or more oxyisobutyric acid esters e.g. methyl-2-hydroxyisobutyrate, ethyl lactate or one or more of the glycol ethers such as 2-methoxyethyl ether (diglyme), ethylene glycol monomethyl ether, and propylene glycol monomethyl ether; solvents that have both ether and hydroxy moieties such as methoxy butanol, ethoxy butanol, methoxy propanol, and ethoxy propanol; esters such as methyl cellosolve acetate, ethyl cellosolve acetate, propylene glycol monomethyl ether acetate, dipropylene glycol monomethyl ether acetate and other solvents such as dibasic esters, propylene carbonate and gamma-butyro lactone. The concentration of the dry components in the solvent will depend on several factors such as the method of application. In general, the solids content of an antireflective composition varies from about 0.5 to 20 weight percent of the total weight of the coating composition, preferably the solids content varies from about 2 to 10 weight of the coating composition.

A variety of photoresist compositions can be employed with coating compositions of the invention, including positive-acting and negative-acting photoacid-generating compositions. Photoresists used with underlying coating compositions of the invention typically comprise a resin binder and a photoactive component, typically a photoacid generator compound. Preferably the photoresist resin binder has functional groups that impart alkaline aqueous developability to the imaged resist composition.

As discussed above, particularly preferred photoresists for use with underlying coating compositions of the invention are chemically-amplified resists, particularly positive-acting chemically-amplified resist compositions, where the photoactivated acid in the resist layer induces a deprotection-type reaction of one or more composition components to thereby provide solubility differentials between exposed and unexposed regions of the resist coating layer. A number of chemically-amplified resist compositions have been described, e.g., in U.S. Pat. Nos. 4,968,581; 4,883,740; 4,810,613; 4,491,628 and 5,492,793, al of which are incorporated herein by reference for their teaching of making and using chemically amplified positive-acting resists. Coating compositions of the invention are particularly suitably used with positive chemically-amplified photoresists that have acetal groups that undergo deblocking in the presence of a photoacid. Such acetal-based resists have been described in e.g. U.S. Patents 5,929,176 and 6,090,526.

Underlying coating compositions of the invention also may be used with other positive resists, including those that contain resin binders that comprise polar functional groups such as hydroxyl or carboxylate and the resin binder is used in a resist composition in an amount sufficient to render the resist developable with an aqueous alkaline solution. Generally preferred resist resin binders are phenolic resins including phenol aldehyde condensates known in the art as novolak resins, homo and copolymers or alkenyl phenols and homo and copolymers of N-hydroxyphenyl-maleimides.

Preferred positive-acting photoresists for use with an underlying coating composition of the invention contains an imaging-effective amount of photoacid generator compounds and one or more resins that are selected from the group of:
1) a phenolic resin that contains acid-labile groups that can provide a chemically amplified positive resist particularly suitable for imaging at 248 nm. Particularly preferred resins of this class include: i) polymers that contain polymerized units of a vinyl phenol and an alkyl acrylate, where the polymerized alkyl acrylate units can undergo a deblocking reaction in the presence of photoacid. Exemplary alkyl acrylates that can undergo a photoacid-induced deblocking reaction include e.g. t-butyl acrylate, t-butyl methacrylate, methyladamantyl acrylate, methyl adamantyl methacrylate, and other non-cyclic alkyl and alicyclic acrylates that can undergo a photoacid-induced reaction, such as polymers in U.S. Patents 6,042,997 and 5,492,793, incorporated herein by reference; ii) polymers that contain polymerized units of a vinyl phenol, an optionally substituted vinyl phenyl (e.g. styrene) that does not contain a hydroxy or carboxy ring substituent, and an alkyl acrylate such as those deblocking groups described with polymers i) above, such as polymers described in U.S. Patent 6,042,997, incorporated herein by reference; and iii) polymers that contain repeat units that comprise an acetal or ketal moiety that will react with photoacid, and optionally aromatic repeat units such as phenyl or phenolic groups; such polymers have been described in U.S. Patents 5,929,176 and 6,090,526, incorporated herein by reference.
2) a resin that is substantially or completely free of phenyl or other aromatic groups that can provide a chemically amplified positive resist particularly suitable for imaging at sub-200 nm wavelengths such as 193 nm. Particularly preferred resins of this class include: i) polymers that contain polymerized units of a non-aromatic cyclic olefin (endocyclic double bond) such as an optionally substituted norbornene, such as polymers described in U.S. Patents 5,843,624, and 6,048,664, incorporated herein by reference; ii) polymers that contain alkyl acrylate units such as e.g. t-butyl acrylate, t-butyl methacrylate, methyladamantyl acrylate, methyl adamantyl methacrylate, and other non-cyclic alkyl and alicyclic acrylates; such polymers have been described in U.S. Patent 6,057,083; European Published Applications EP01008913A1 and EP00930542A1; and U.S. pending Patent Application No. 09/143,462, all incorporated herein by reference, and iii) polymers that contain polymerized anhydride units, particularly polymerized maleic anhydride and/or itaconic anhydride units, such as disclosed in European Published Application EP01008913A1 and U.S. Patent 6,048,662, both incorporated herein by reference.
3) a resin that contains repeat units that contain a hetero atom, particularly oxygen and/or sulfur (but other than an anhydride, i.e. the unit does not contain a keto ring atom), and preferable are substantially or completely free of any aromatic units. Preferably, the heteroalicyclic unit is fused to the resin backbone, and further preferred is where the resin comprises a fused carbon alicyclic unit such as provided by polymerization of a norborene group and/or an anhydride unit such as provided by polymerization of a maleic anhydride or itaconic anhydride. Such resins are disclosed in PCT/US01/14914 and U.S. application number 09/567,634.
4) a resin that contains fluorine substitution (fluoropolymer), e.g. as may be provided by polymerization of tetrafluoroethylene, a fluorinated aromatic group such as fluoro-styrene compound, and the like. Examples of such resins are disclosed e.g. in PCT/US99/21912.

Suitable photoacid generators to employ in a positive or negative acting photoresist overcoated over a coating composition of the invention include imidosulfonates such as compounds of the following formula: 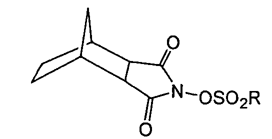 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable PAGs for resists overcoated a coating composition of the invention, particularly sulfonate salts. Two suitable agents for 193 nm and 248 nm imaging are the following PAGS 1 and 2:

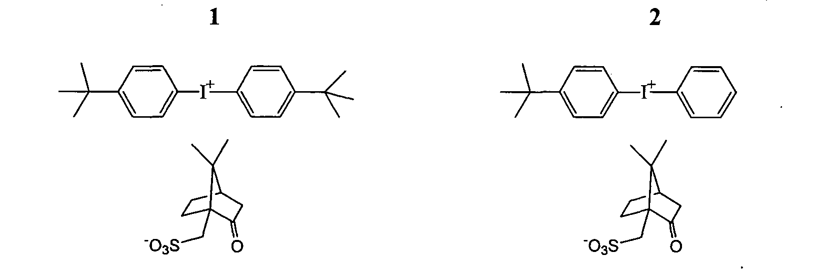

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

Other known PAGS also may be employed in the resists of the invention.

A preferred optional additive of photoresists overcoated a coating composition of the invention is an added base, particularly tetrabutylammonium hydroxide (TBAH), or tetrabutylammonium lactate, which can enhance resolution of a developed resist relief image. For resists imaged at 193 nm, a preferred added base is a hindered amine such as diazabicyclo undecene or diazabicyclononene. The added base is suitably used in relatively small amounts, e.g. about 0.03 to 5 percent by weight relative to the total solids.

Preferred negative-acting resist compositions for use with an overcoated coating composition of the invention comprise a mixture of materials that will cure, crosslink or harden upon exposure to acid, and a photoacid generator.

Particularly preferred negative-acting resist compositions comprise a resin binder such as a phenolic resin, a crosslinker component and a photoactive component of the invention. Such compositions and the use thereof have been disclosed in European Patent Applications 0164248 and 0232972 and in U.S. Pat. No. 5,128,232 to Thackeray et al. Preferred phenolic resins for use as the resin binder component include novolaks and poly(vinylphenol)s such as those discussed above. Preferred crosslinkers include amine-based materials, including melamine, glycolurils, benzoguanamine-based materials and urea-based materials. Melamine-formaldehyde resins are generally most preferred. Such crosslinkers are commercially available, e.g. the melamine resins sold by American Cyanamid under the trade names Cymel 300, 301 and 303. Glycoluril resins are sold by American Cyanamid under trade names Cymel 1170, 1171, 1172, Powderlink 1174, urea-based resins are sold under the tradenames of Beetle 60, 65 and 80, and benzoguanamine resins are sold under the trade names of Cymel 1123 and 1125.

Photoresists for use with an underlying coating composition of the invention also may contain other materials. For example, other optional additives include actinic and contrast dyes, anti-striation agents, plasticizers, speed enhancers, etc. Such optional additives typically will be present in minor concentration in a photoresist composition except for fillers and dyes which may be present in relatively large concentrations such as, e.g., in amounts of from about 5 to 50 percent by weight of the total weight of a resist's dry components.

In use, a coating composition of the invention is applied as a coating layer to a substrate by any of a variety of methods such as spin coating. The coating composition in general is applied on a substrate with a dried layer thickness of between about 0.02 and 0.5 µm, preferably a dried layer thickness of between about 0.04 and 0.20 µm. The substrate is suitably any substrate used in processes involving photoresists. For example, the substrate can be silicon, silicon dioxide or aluminum-aluminum oxide microelectronic wafers. Gallium arsenide, silicon carbide, ceramic, quartz or copper substrates may also be employed. Substrates for liquid crystal display or other flat panel display applications are also suitably employed, for example glass substrates, indium tin oxide coated substrates and the like. Substrates for optical and optical-electronic devices (e.g. waveguides) also can be employed.

Preferably the applied coating layer is cured before a photoresist composition is applied over the composition layer, as discussed above, with a dual bake cure being preferred.

After such curing, a photoresist is applied over the surface of the coating composition. As with application of the bottom coating composition, the overcoated photoresist can be applied by any standard means such as by spinning, dipping, meniscus or roller coating. Following application, the photoresist coating layer is typically dried by heating to remove solvent preferably until the resist layer is tack free. Optimally, essentially no intermixing of the bottom composition layer and overcoated photoresist layer should occur.

The resist layer is then imaged with activating radiation through a mask in a conventional manner. The exposure energy is sufficient to effectively activate the photoactive component of the resist system to produce a patterned image in the resist coating layer. Typically, the exposure energy ranges from about 3 to 300 mJ/cm² and depending in part upon the exposure tool and the particular resist and resist processing that is employed. The exposed resist layer may be subjected to a post-exposure bake if desired to create or enhance solubility differences between exposed and unexposed regions of a coating layer. For example, negative acid-hardening photoresists typically require post-exposure heating to induce the acid-promoted crosslinking reaction, and many chemically amplified positive-acting resists require post-exposure heating to induce an acid-promoted deprotection reaction. Typically post-exposure bake conditions include temperatures of about 50°C or greater, more specifically a temperature in the range of from about 50°C to about 160°C.

The exposed resist coating layer is then developed, preferably with an aqueous based developer such as an alkali exemplified by tetra butyl ammonium hydroxide, sodium hydroxide, potassium hydroxide, sodium carbonate, sodium bicarbonate, sodium silicate, sodium metasilicate, aqueous ammonia or the like. Alternatively, organic developers can be used. In general, development is in accordance with art recognized procedures. Following development, a final bake of an acid-hardening photoresist is often employed at temperatures of from about 100°C to about 150°C for several minutes to further cure the developed exposed coating layer areas.

The developed substrate may then be selectively processed on those substrate areas bared of photoresist, for example, chemically etching or plating substrate areas bared of photoresist in accordance with procedures well known in the art. Suitable etchants include a hydrofluoric acid etching solution and a plasma gas etch such as an oxygen plasma etch. A plasma gas etch removes the underlying organic composition coating layer.

The following non-limiting examples are illustrative of the invention. All documents mentioned herein are incorporated herein by reference.

### Examples 1-4: Syntheses of Thermal Acid Generator Compounds:

### Example 1

p-Toluenesulfonic acid monohydrate (123.9, 0.65 mol) was dissolved in methyl-2-hydroxyisobutyrate (3610.0g) with agitation over 40min. at 21 deg C. Triethylamine (69.3g, 0.68mol) was added.

### Example 2

p-Toluenesulfonic acid monohydrate (7.5g, 39.6 mmol) and 2-hydroxyisobutyric acid (2.3g, 22.1 mmol) were dissolved in methanol (21.9g) and distilled, deionized water (44.6g). A 2M solution of ammonia in methanol (23.7g, 60.2 mmol) was added via syringe.

### Example 3

Dodecylbenzenesulfonic acid (0.96, 2.9 mmol) was dissolved in methyl-2-hydroxyisobutyrate (97.9g). A 2M solution of ammonia in methanol (1.11g, 2.9 mmol) was added via syringe.

### Example 4

Mesitylenesulfonic acid dihydrate (0.93g, 4.0 mmol) was dissolved in methyl-2-hydroxyisobutyrate (97.5g). A 2M solution of ammonia in methanol (1.51g, 4.0 mmol) was added via syringe.

### Example 5-18: Polymer syntheses

### Example 5: Polymer particularly suitable for 193 nm ARC

Charge: dimethyl terephthalate (31.15g, 16.04 mmol), 1,3,5-tris(2-hydroxyethyl)cyanuric acid (46.09g, 17.64 mmol), p-toluenesulfonic acid monohydrate (PTSA) (1.35g, 0.710 mmol) and anisole (52g). The resultant polymer was dissolved in tetrahydrofuran (THF), and precipitated into isopropyl alcohol to obtain 45.3g (67%).

### Example 6: Polymer particularly suitable for 193 nm ARC

Charge: dimethyl nitroterephthalate (12.48g, 52.17 mmol), dimethyl 1,4- - cyclohexanedicarboxylate (4.9 1 g, 24.5 mmol), dimethyl phthalate (2.34g, 12.0 mmol), dimethyl isophthalate (2.34g, 12.0 mmol), isosorbide (5.86g, 40.1 mmol), glycerol (2.81g, 30.5 mmol), p-toluenesulfonic acid monohydrate (PTSA) (0.26g, 1.4 mmol) and toluene (20mL). The resultant polymer was dissolved in tetrahydrofuran (THF); and precipitated in mixture of t-butylmethyl ether (MTBE) and hexanes to obtain 11.6g (42%).

### Example 7: Polymer particularly suitable for 193 nm ARC

Charge: dimethyl isophthalate (18.52g, 95.37 mmol), dimethyl phthalate (2.33g, 12.0 mmol), 1,3,5-tris(2-hydroxyethyl)cyanuric acid (15.63g, 59.39 mmol), glycerol (4.80g, 52.1 mmol), and PTSA (0.54g, 2.8 mmol). The resultant polymer was dissolved in THF. The polymer could be precipitated from water, isopropanol (IPA), or MTBE. Collectively, 26g (70%) of polymer was obtained.

### Example 8: Polymer particularly suitable for 193 nm ARC

Charge: dimethyl nitroterephthalate (18.26g, 76.34 mmol), dimethyl isophthalate (2.33g, 12.0 mmol), dimethyl phthalate (2.33g, 12.0 mmol), 1,3,5-tris(2-hydroxyethyl)cyanuric acid (15.91g, 60.91 mmol), glycerol (5.58g, 60.6 mmol), and PTSA (0.55g, 2.9 mmol). The resultant polymer was dissolved in THF, and precipitated in MTBE to obtain 26g (69%).

### Example 9: Polymer particularly suitable for 193 nm ARC

Charge: dimethyl nitroterephthalate (45.5g, 190 mmol), dimethyl isophthalate (5.8g, 30mmol), dimethyl phthalate (5.8g, 30 mmol), 1,3,5-tris(2-hydroxylethyl)cyanuric acid (39.2g, 150 mmol), glycerol (14.3g, 155 mmol), and PTSA (1.1g, 5.8 mmol). The resultant polymer was dissolved in enough methyl 2-hydroxyisobutyrate (HBM) to prepare a 9.5% solution.

### Example 10: Polymer particularly suitable for 193 nm ARC

Charge: dimethyl nitroterephthalate (58.7g, 245 mmol), glycerol (27.1g, 294 mmol), and para-toluene sulfonic acid monohydrate (PTSA) (0.57g, 3.0 mmol). Enough methyl 2-hydroxyisobutyrate (HBM) was added to prepare an 11% solution.

### Example 11: Polymer particularly suitable for 193 nm ARC and 248 nm ARC

Charge: dimethyl terephthalate (48.5g, 250 mmol), ethylene glycol (12.4g, 200 mmol), glycerol (9.0g, 100 mmol), and PTSA (0.54g, 2.8 mmol). Enough propylene glycol methyl ether acetate (PMA) was added to prepare an 8% solution.

### Example 12: Polymer particularly suitable for 248 nm ARC

Charge: dimethyl 2,6-naphthalenedicarboxylate (24.33g, 99.63 mmol), dimethylterephthalate (19.44g, 100.1 mmol), ethylene glycol (7.63g, 123 mmol), glycerol (7.29g, 79.2 mmol), and PTSA (0.46g, 2.4 mmol). The resultant polymer was dissolved in a solvent mixture of HBM, anisole, and methyl 2-methoxyisobutyrate (MBM) to prepare a 10% solution.

### Example 13: Polymer particularly suitable for 248 nm ARC

Charge: dimethyl 2,6-naphthalenedicarboxylate (30.5g, 125 mmol), dimethylterephthalate (14.5g, 74.7 mmol), ethylene glycol (7.20g, 116 mmol), glycerol (7.30g, 79.3 mmol) and PTSA (0.47g, 2.5 mmol). The resultant polymer was dissolved in a mixture of anisole and tetrahydrofurfuryl alcohol to prepare a 10% solution.

### Example 14: Polymer particularly suitable for 248 ARC

Charge: dimethyl 2,6-naphthalenedicarboxylate (47.70g, 195.3 mmol), dimethyl terephthalate (25.90g, 133.4 mmol), glycerol (32.90g, 357.2 mmol), PTSA (0.84g, 4.4 mmol), and anisole (36g). The resultant polymer was dissolved in a mixture of methyl-2-hydroxyisobutyrate (HBM) and anisole to prepare 10% solution.

### Example 15: Polymer particularly suitable for 248 nm ARC

Charge: dimethyl 2,6-naphthalenedicarboxylate (25.61g, 104.8 mmol), dimethyl terephtalate (13.58g, 69.93 mmol), glycerol (16.72g, 181.5 mmol), PTSA (0.45g, 2.4 mmol), and anisole (18.8g). The resultant polymer was dissolve in THF and precipitated in IPA to obtain 36.9g (83%).

### Example 16: Polymer particularly suitable for 193 nm ARC

Charge: dimethyl nitroterephthalate (31.78g, 132.9 mmol), dimethyl isophthalate (4.09g, 21.1 mmol), and dimethyl phthalate (4.10g, 21.1 mmol), 1,3,5-tris (2-hydroxyethyl)cyanuric acid (27.42g, 105.0 mmol), gylcerol (9.65g, 105 mmol), PTSA (0.65g, 3.4 mmol), and anisole (25g). The resultant polymer was dissolved in THF and precipitated in MTBE to obtain 47.2g (72%).

### Example 17: Polymer particularly suitable for 193 nm ARC

A terpolymer consisting of styrene, 2-hydroxethylmethacrylate and methylmethacrylate monomers with a mole ratio of 30:38:32 was synthesized according to the following procedure:

The monomers (styrene, 99% pure from Aldrich, 169.79 g; 2-hydoxyethylmethacrylate obtained from Rohm and Haas Corporation "Rocryl 400", 269.10 g; and methylmethacrylate obtained from Rohm & Haas Corporation, 173.97 g), were dissolved in 2375 g of THF in a 5L 3-neck round bottom fitted with overhead stirring, a condenser, and a nitrogen inlet. The reaction solution was degassed with a stream of nitrogen for 20 min. The Vazo 52 initiator (11.63g, from DuPont Corporation) was added and the solution was heated to reflux (65-67°C). This temperature was maintained for 15 hours. The reaction solution was cooled to room temperature and precipitated into 12L of MTBE/cyclohexane (v/v 1/1). The polymer was collected by vacuum filtration and vacuum dried at 50°C for 48 hours. Yield = 68%, and subsequent analysis found the residual monomers = 2.4 wt%, Tg = 92°C, Td = 239°C. The mole concentration of the Vazo 52 initiator relative to the sum of the mole concentration of monomers was 0.72%. Molecular weight analysis by gel permeation chromatography relative to polystyrene standards gave a Mw = 22416, Mn = 10031.

### Example 18: Polymer particularly suitable for 248 nm ARC

9-anthracdnemethyl methacrylate (155.63 g), 2-hydroxyethyl methacrylate (650.07 g) and methyl methacrylate (65.62 g) were dissolved in 1850 g of ethyl lactate. The solution was degassed with a stream of dry nitrogen for 15 minutes and heated to 50°C. The polymerization initiator [2,2'-azobis(2-methylbutanenitrile] (23.217 g) was dissolved in 110 g of ethyl lactate and this solution was rapidly added to the reaction flask; heating was continued to 85°C and maintained for 24 hours. The solution was cooled to room temperature. The polymer product was isolated by precipitation into 12 L of deionized water and dried in vacuum. Molecular weight (Mw vs. polystyrene standards) 8355; Tg 103°C.

### Formulation Synthesis Examples 19-23

### Example 19

Polyester of example 5 in methyl-2-hydroxyisobutyrate (5.59g, 19.66 % solids), tetramethoxyglycouril in methyl-2-hydroxyisobutyrate (5.60g, 5.00 % solids), and TAG from example 1 (0.164g) were mixed with methyl-2-hydroxyisobutyrate (23.61g) and filtered through a 0.2um Teflon filter.

### Example 20

Polyester of example 5 in methyl-2-hydroxyisobutyrate (5.62g, 19.66 % solids), tetramethoxyglycouril in methyl-2-hydroxyisobutyrate (5.60g, 5.00 % solids), and TAG from Example 2 (0.163g) above were mixed with methyl-2-hydroxyisobutyrate (23.61g) and filtered through a 0.2um Teflon filter.

### Example 21

Polyester of example 5 in methyl-2-hydroxyisobutyrate (5.56g, 19.66 % solids), tetramethoxyglycouril in methyl-2-hydroxyisobutyrate (5.60g, 5.00 % solids), TAG from Example 4 (2.24g) above, and ammonium 2-hydroxyisobutyric acid in methyl-2-hydroxyisobutyrate (0.12g, 3 %solids) were mixed with methyl-2-hydroxyisobutyrate (21.48g) and filtered through a 0.2um Teflon filter.

### Example 22

Polyester of example 5 in methyl-2-hydroxyisobutyrate (5.53g, 19.66 % solids), tetramethoxyglycouril in methyl-2-hydroxyisobutyrate (5.60g, 5.00 % solids), TAG from Example 3 (3.01 g) above, and ammonium 2-hydroxyisobutyric acid in methyl-2-hydroxyisobutyrate (0.12g, 3 %solids) were mixed with methyl-2-hydroxyisobutyrate (20.77g) and filtered through a 0.2um Teflon filter.

### Example 23

Polyester of example 5 in methyl-2-hydroxyisobutyrate (5.58g, 19.66 % solids), tetramethoxyglycouril in methyl-2-hydroxyisobutyrate (5.60g, 5.00 % solids), TAG created in-situ from p-toluenesulfonic acid in methyl-2-hydroxyisobutyrate (1.65g, 1 %solids), dimethylamine in methyl-2-hydroxyisobutyrate (0.39g, 1 %solids), and ammonium 2-hydroxyisobutyric acid in methyl-2-hydroxyisobutyrate (0.12g, 3 %solids) were mixed with methyl-2-hydroxyisobutyrate (20.77g) and filtered through a 0.2um Teflon filter.

### Examples 24-28: Testing Onset of Thermal Acid Generation

For each formulation of Examples 24-28, the procedure described below was followed for testing onset of thermal acid generation:

The formulation was spin coated onto six 4-inch silicon wafers using a table top coater operating at 2500rpm. The six coated wafers were thermally cured for 60s at, respectively, 80°C, 90°C, 95°C, 100°C, 105°C, and 110°C. The thickness of the cured films was measured using a Nano210 film thickness measurement tool. The cured films were submerged in ethyl lactate for 60 seconds, rinsed with distilled, de-ionized water, and blown dry with nitrogen. The thickness of the films was re-measured. Results are set forth in the following Table 1.

**Table 1.**

| Percentage of film stripped off of a silicon wafer by immersion in ethyl lactate after a 60seconds cure at the indicated temperature. | | | | | | | | |
|---|---|---|---|---|---|---|---|---|
| Example No. | ARC of Example # | TAG | 80C | 90C | 95C | 100C | 105C | 110C |
| Example 24 | Example 19 | PTSA-TEA | 100% | 100% | 100% | 100% | 24% | 0% |
| Example 25 | Example 20 | PTSA-NH3 | 100% | 100% | 32% | 10% | 4% | 0% |
| Example 26 | Example 21 | MesSA-NH3 | 100% | 100% | 8% | 12% | 4% | -1% |
| Example 27 | Example 22 | DDBSA-NH3 | 100% | 100% | 202%* | 14% | 6% | 0% |
| Example 28 | Example 23 | pTSA-Me2NH | 100% | 100% | 72% | 41% | 10% | -1% |

| | | | | | | | | |
|---|---|---|---|---|---|---|---|---|
| * Film swelled. | | | | | | | | |

In Table 1 above, the specified thermal acid generator (TAG) is the thermal acid generator of the specified Example 19 through 23, i.e. PTSA-TEA is para-toluenesulfonic acid triethylamine salt; PTSA-NH3 is para-toluenesulfonic acid ammonia salt; MesSA-NH3 is mesitylene sulfonic acid ammonia salt; DDBSA-NH3 is dodecylbenzenesulfonic acid ammonia salt; and pTSA-Me2NH para-toluenesulfonic acid dimethylamine salt.

### Examples 29-31: Processing of coating compositions of the invention

### Example 29:

The coating composition of Example 19 with a thermal acid generator of p-toluene sulfonic acid triethylamine salt was spin coated on a 4-inch silicon wafer with a patterned 230nm silicon oxide layer using a table top coater operating at 2500 rpm. The coated wafer was thermally cured for 60 seconds at 215oC. Microscopic inspection of the cured coating layer showed that the film thinned at edges of the coating layer (patterned layer).

### Example 30:

The coating composition of Example 20 with a thermal acid generator of p-toluene sulfonic acid ammonia salt was spin coated on a 4-inch silicon wafer with a patterned 230nm silicon oxide layer using a table top coater operating at 2500 rpm. The coated wafer was thermally cured for 60 seconds at 215°C. Microscopic inspection of the cured coating layer showed that the film did not thin at edges of the coating layer (patterned layer).

### Example 32:

The coating composition of Example 21 with a thermal acid generator of mesitylene sulfonic acid ammonia salt was spin coated on a 4-inch silicon wafer with a patterned 230nm silicon oxide layer using a table top coater operating at 2500 rpm. The coated wafer was thermally cured for 60 seconds at 215oC. Microscopic inspection of the cured coating layer showed that the film did not thin at edges of the coating layer (patterned layer).

The foregoing description of this invention is merely illustrative thereof, and it is understood that variations and modifications can be made without departing from the spirit or scope of the invention as set forth in the following claims.

## Claims

1. A coated substrate comprising:
an underlying organic composition layer comprising a resin and an ionic thermal acid generator compound that comprises a cation component that has a molecular weight of less than 100; and
a photoresist layer over the organic composition layer.

2. A coated substrate comprising:
an underlying organic composition layer comprising a resin and a thermal acid generator compound that produces acid upon heating at 150°C for 30 seconds or less; and
a photoresist layer over the organic composition layer.

3. The substrate of claim 1 or 2 wherein the thermal acid generator compound is an ionic compound with a counter ion of ammonia.

4. The substrate of claim 1 or 2 wherein the organic composition comprises a resin having a weight average molecular weight of at least about 20,000 daltons and/or a resin that has a glass transition temperature of at least about 80°C.

5. A method for processing a substrate, comprising:
applying a liquid coating layer of an organic composition on a substrate surface;
first heating the applied composition coating layer to remove organic solvent;
after the first heating, heating the application composition coating layer to harden the coating layer;
applying a photoresist layer over the hardened composition coating layer,
wherein the maximum temperature of the first heating is at least about 20°C lower than the maximum temperature of the heating to harden the composition coating layer.

6. The method of claim 5 wherein the organic composition comprises a resin and a thermal acid generator compound.

7. A method for processing a substrate, comprising:
applying a coating layer of an organic composition on a substrate surface, the organic composition comprising a resin and an ionic thermal acid generator compound that comprises a cation component that has a molecular weight of less than 100;
applying a photoresist layer over the organic composition coating layer.

8. A method for processing a substrate, comprising:
applying a coating layer of an organic composition on a substrate surface, the organic composition comprising a resin and a thermal acid generator compound that produces acid upon heating at 150°C for 30 seconds or less;
applying a photoresist layer over the organic composition coating layer.

9. An organic antireflective coating composition comprising:
a resin and a thermal acid generator compound that and an ionic thermal acid generator compound that comprises a cation component that has a molecular weight of less than 100.

10. An organic antireflective coating composition comprising:
a resin and a thermal acid generator compound that produces acid upon heating at 150°C for 30 seconds or less.
